# EUROPEAN PATENT SPECIFICATION

(11) **EP 0 281 156 B1**
(45) Date of publication and mention of the grant of the patent: **13.07.1994**
(21) Application number: 88103402.9
(22) Date of filing: 04.03.1988
(51) Int. Cl.: H01L 29/80, H01L 29/46, H01L 39/24, H01L 39/22

(54) **Semiconductor-coupled three-terminal superconducting device having a junction gate structure**
Supraleiterbauelement mit drei Anschlüsse und Halbleiterkopplung sowie einer Jonction-Gate-Struktur
Dispositif supraconducteur à trois bornes et à couplage par semi-conducteur ayant une structure de porte du type jonction

(30) Priority: 06.03.1987 JP 52339/87
(43) Date of publication of application: 07.09.1988
(73) Proprietor: NEC CORPORATION, Tokyo (JP)
(72) Inventor: Ishida, Ichiro c/o NEC Corporation, Minato-ku Tokyo (JP)
(74) Representative: Glawe, Delfs, Moll & Partner

(56) References cited:
- EP-A- 0 160 456
- PATENT ABSTRACTS OF JAPAN vol. 10, no. 363 (E-461)(2420), 5 December 1986; & JP-A-61 158187

## Description

### BACKGROUND OF THE INVENTION

### Field of the Invention

The present invention relates to a semiconductor-coupled superconducting device and, more particularly, to a semiconductor-coupled superconducting device having a field-effect-transistor type three-terminal structure.

### Description of the Prior Art

In order to apply the superconducting device to integrated circuits or the like, it is necessary to develop a three-terminal structure providing excellent controllability of superconducting current. As this kind of three-terminal superconducting device, there has been proposed a gate-controlled, semiconductor-coupled superconducting transistor using an insulated gate.

The gate-controlled superconducting transistor is a device for controlling a superconducting current flowing between its source and drain by controlling a degree of superposition of the wave functions of superconducting electrons (or Cooper pairs) spreading into a semiconductor from two superconducting electrodes used as the source and drain electrodes, with a gate voltage. The spacial distance for the amplitude (or order parameter) of the wave functions of the superconducting electrons spreading into the semiconductor to attenuate to a predetermined value (e.g., l/e) is called the "coherence length". The longer the coherence length, the larger the degree of superposition of the wave functions of the superconducting electrons and the amount of the superconducting current become. Since the coherence length ξ has a relation of ξ ∝ N^{1/3} to a carrier concentration N, the coherence length of the superconducting electrons can be changed by changing the gate voltage and accordingly the carrier concentration. Thus, the superconducting current flowing between the source and the drain is controlled by changing the gate voltage.

In one type of the semiconductor-coupled superconducting device in the prior art, a thin Si single-crystal layer is equipped on its surface with two electrodes of a superconducting substance acting as the source and drain electrodes and on its back face with a gate oxide film and a gate electrode, as disclosed in "Three-Terminal Superconducting Device Using a Si Single-Crystal Film", by T. Nishino et al., IEEE, Electron Device Letters, Vol. EDL-6, No. 6, 1986. In order to exert influences efficiently upon the coherence length of the superconducting electrons spread from the superconductor electrodes by changing the gate voltage and accordingly the carrier concentration of the Si single-crystal layer, it is necessary for the Si single-crystal layer to have a thickness of about 100 nm with a gate oxide film of a thickness of about 40 nm. Moreover in order to make the operating characteristics of the superconducting transistors uniform over a single integrated circuit chip, it is necessary to uniformalize the thicknesses of the Si single-crystal layer and the gate oxide film. It is, however, very difficult to form in an IC chip such thin Si single-crystal layer and gate oxide film having excellently uniform thicknesses and qualities without any defect such as pin-holes. Moreover, the thin layer and film thus formed are weak in mechanical strength and low in reliability.

In another type of the semiconductor-coupled superconducting device in the prior art, source and drain superconductor electrodes are buried in the surface of a p-type InAs and a gate oxide film and a gate electrode are formed thereon, as disclosed in "Planar-Type InAs-Coupled Three-Terminal Superconducting Devices" by H. Takayanagi et al., Proceedings of the IEDM 85, pp 98. In this device, the surface potential of the inversion layer of a p-InAs is controlled with the gate voltage, so that the thickness of the gate oxide must be about 100 nm. Moreover, in order to uniformalize the operating characteristics of the superconducting transistors in an IC chip, it is necessary to uniformalize the thickness of the gate oxide file. It is, however, also very difficult to form on the semiconductor and the superconductor electrodes in the IC chip such thin gate oxide film with an excellently uniform thickness and quality without the pin-holes or other defects. Moreover, SiO is used for the gate oxide film in the Takayanagi's device. However, SiO is an unstable compound and may fluctuate the element characteristics.

Furthermore, in another type of the semiconductor-coupled superconducting device of the prior art, a silicon substrate is formed with a p-type buried electrode and also with an n-type channel layer, which lie in contact through a p-n junction, and first and second superconducting electrode are disclosed at end parts of said n-type channel layer, as disclosed in the European Patent Application 0 160 456 (D1). In this device, a superconducting current flowing across the superconducting electrodes is controlled by a voltage which is applied to the p-type buried electrode, thereby enhancing the current gain.

In another example of the superconducting three-terminal-device in the prior art, a semiconductor layer having reverse conductive type to a substrate in composed on a semiconductor substrate, and furthermore superconductive source and drain layers are formed on it. Next, the channel part between a source layer and drain layer, is made thin by etching said semiconductor electrodes, as disclosed in PATENT ABSTRACTS OF JAPAN, vol. 10, No. 363 (D2). By this structure, it is possible to control the superconductive current.

### SUMMARY OF THE INVENTION

It is, therefore, a primary object of the present invention to provide a semiconductor-coupled superconducting device which can attain uniform element characteristics and high production yield and integration without any necessity for forming a thin semiconductor layer and a thin insulating film below a gate electrode.

The semiconductor-coupled superconducting device according to the present invention is defined in the appended claims
Superconducting electrons are spread from the first and second superconductor electrodes into the surface portion of the second semiconductor layer. The coherence length ξ of the superconducting electrons which are spread into the second semiconductor layer has a relation of ξ ∝ N^{1/3} to the carrier concentration N below the principal surcace of the second semiconductor layer. By changing the carrier concentration N in the vicinity of the surface of the second semiconductor layer, therefore, the coherence length ξ is changed to control the superconducting current depending upon the degree of superposition of the wave functions of the superconducting electrons.

In the present invention, by changing the bias voltage applied to the pn junction established between the first semiconductor layer of one conductivity type and the second semiconductor layer of the other conductivity type, the width (W) of a depletion layer extending from the pn junction and having a carrier concentration N of about zero is changed. Since this depletion layer is extended the longer from the pn junction to the surface of the second semiconductor layer as the backward bias voltage applied to the pn junction is increased the more, the carrier concentration N of the second semiconductor layer will be reduced to shorten the coherence length of the superconducting electrons and to decrease the superposition of the wave functions of the superconducting electrons. Thus, the superconducting current flowing between the two superconductor electrodes can be controlled by controlling the backward bias voltage to be applied between the first and second semiconductor layers.

Accordingly, the semiconductor-coupled superconducting device according to the present invention can be manufactured with ease by forming the pn junction on a surface of a semiconductor substrate having an ordinary thickness because the superconducting current is controlled with the width of the depletion layer extending from the pn junction. This makes it possible to uniformalize the element characteristics and to increase the production yield and integration without any necessity for forming remarkably thin semiconductor layer and insulating film.

Since, moreover, the superconducting current flowing between the two superconductor electrodes is controlled with the backward bias voltage applied to the pn junction, it is possible to provide a device which has an excellent controllability of the superconducting current.

### BRIEF DESCRIPTION OF THE DRAWINGS

The above and further objects, features and advantages of the present invention will become more apparent from the following detailed description taken in conjunction with the accompanying drawings, wherein:
Fig. 1 is a sectional view showing a known semiconductor-coupled superconducting device;
Fig. 2 is a sectional view showing a semiconductor-coupled superconducting device in accordance with a first embodiment of the present invention;
Fig. 3 is a sectional view showing a semiconductor-coupled superconducting device in accordance with a second embodiment of the present invention;
Fig. 4 is a perspective view showing a semiconductor-coupled superconducting device in accordance with the second embodiment of the present invention;
Fig. 5 is a diagram showing the current-voltage characteristics of the semiconductor-coupled superconducting device in accordance with the second embodiment of the present invention;
Figs. 6(a) to 6(d) are sectional views showing principal steps for manufacturing the semiconductor-coupled superconducting device in accordance with the second, third and fourth embodiments of the present invention; and
Fig. 7 is a diagram showing the current-voltage characteristics of the semiconductor-coupled superconducting device in accordance with the third embodiment of the present invention.

### DESCRIPTION OF THE PREFERRED EMBODIMENTS

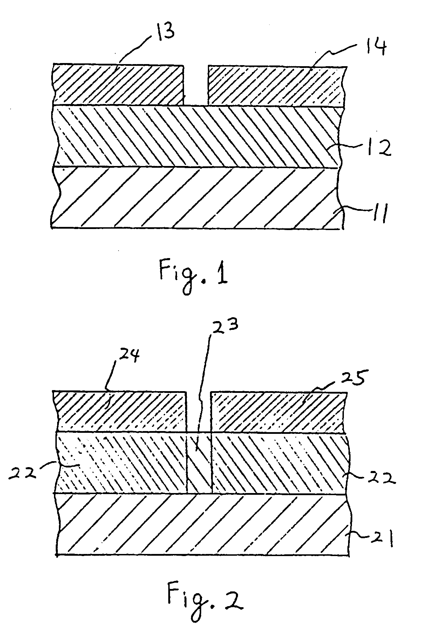

Referring to Fig. 1, a known semiconductor-coupled superconducting device comprises an n-type silicon substrate 11 and a p-type region 12 which is formed by implanting boron (B) into the substrate 11 at a concentration of 5 x 10²⁰ atoms/cm³. First and second superconductor electrodes 13 and 14 are formed on the surface of the p-type region 12. They are made of niobium (Nb) and have a thickness of 300 nm. The distance between the superconductor electrodes 13 and 14 is 200 nm, and the thickness of the p-type region 12 just below the electrodes 13 and 14 is 200 nm. The superconducting current flowing between the first and second superconductor electrodes 13 and 14 is controlled by the voltage to be applied backwardly between the n-type substrate 11 and the p-type region 12.

Referring to Fig 2, a first embodiment of the present invention comprises an n-type silicon substrate 21 containing phosphorous (P) in a concentration of 3 x 10¹⁷ atoms/cm³, a p⁺-type region 22 which is formed by implanting boron into a part of the surface of the substrate 21 in a concentration of 5 x 10²⁰ atoms/cm³, and a p⁻-type region 23 which is formed by implanting boron into the remaining part of the surface of the substrate in a concentration of 5 x 10¹⁹ atoms/cm³. A pair of superconductor electrodes 24 and 25 made of Nb films having a thickness of 300 nm, are formed on the surface of the p⁺-type region 22. The distance between the first and second superconductor electrodes 24 and 25 is 200 nm, and the thicknessess of the p⁺-type region 22 and p⁻-type region 23 are 200 nm.

As has been described hereinbefore, the carrier concentration N of the semiconductor layer below the superconductor electrodes and the coherence length ξ of the superconducting electrons (Cooper pairs) have the relation of ξ ∝ N^{1/3}. In other words, for the higher carrier concentration, the coherence length becomes the larger so that the distance between the two superconductor electrodes can be elongated the more. As a result, the lithography process for forming the superconductor electrodes can be facilitated the better with the more superconducting current, if the carrier concentration of the semiconductor layer is made the higher. The superconducting current flowing between the superconductor electrodes is controlled by the width of the depletion layer extending from the pn junction towards the surface. The width of the depletion layer has a character to increase in inverse proportion to the carrier concentration. Therefore, if the semiconductor layer below the superconductor electrodes is made to have a high concentration uniformally, the distance between the superconductor electrodes can be relatively long, but the changing rate of the superconducting current to the backward bias voltage applied to the pn junction would be small. Since, in the present embodiment, the semiconductor layer below the superconductor electrodes is the highly doped p⁺-type region 22, the coherence length of the superconductor electrons spread from the two superconductor electrodes 24 and 25 into the semiconductor layer is enlarged so that the distance between the two electrodes can be relatively enlarged and a large superconducting current can be obtained. Moreover, there is a p⁻-type region 23 of a low impurity concentration between the two superconductor electrodes 24 and 25. Therefore the depletion layer can be easily extended from the pn junction towards the surface so that the superconducting current between the two electrodes can be easily controlled. Thus, as in the present embodiment, by making the semiconductor layer highly doped below the superconductor electrodes and lightly doped therebetween, it becomes possible to enlarge the distance between the superconductor electrodes, the superconducting current flowing therebetween, and the changing rate of the superconducting current against the backward bias voltage applied to the pn junction.

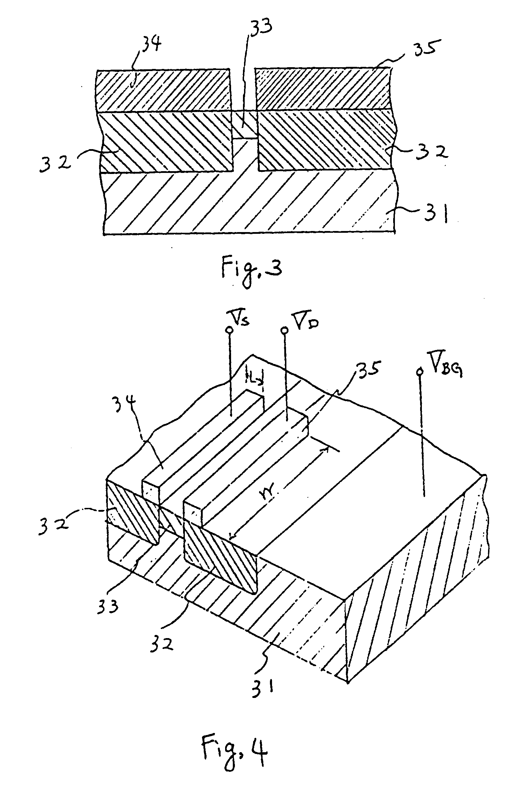

Fig. 3 is a sectional view and Fig. 4 is a perspective view, both showing a second embodiment of the present invention. An n-type silicon (111) substrate 31 containing impurity of P of 3 x 10¹⁷ atoms/cm³ is implanted with B in a concentration of 5 x 10²⁰ atoms/cm³ to form a p⁺-type region 32 and in a concentration of 5 x 10¹⁹ atoms/cm³ to form a p⁻-type region 33. First and second superconductor electrodes 34 and 35 made of Nb films of a thickness of 300 nm are formed on the principal surface of the p⁺-type region 32. The distance between the first and second superconductor electrodes 34 and 35 is 200 nm, and the p⁺-type region 32 has a thickness of 200 nm whereas the p⁻-type region 33 has a thickness of 100 nm. The n-type silicon substrate 31, the first superconductor electrode 34 and the second superconductor electrode 35 are connected with terminals V_{BG}, V_{S}, V_{D}, respectively.

When the highly doped p⁺-type semiconductor region 32 below the superconductor electrodes 34 and 35 is deepened, the wave functions of the superconducting electrons spread into the semiconductor region below the electrodes can be extended up to the coherence length of the superconducting electrons determined by the carrier concentration of the semiconductor region. It is, therefore, desirable to increase the thickness of the highly-doped semiconductor layer below the superconductor electrodes to the coherence length. Incidentally, if the thickness of the highly-doped semiconductor layer becomes larger than the coherence length, the wave functions of the superconducting electrons does not extend over the coherence length.

The amplitude (or order parameter) of the wave functions of the superconducting electrons spreading from the superconductor electrodes takes its maximum at the interface between the superconductor electrodes and the semiconductor layer and becomes the smaller for the position the further apart from the interface. In the semiconductor layer between the two superconductor electrodes, the amplitude of the wave functions of the superconducting electrons also takes its maximum on the surface and becomes the smaller for the deeper position. In order to enlarge the changing rate of the superconducting current to the backward bias voltage applied to the pn junction and control and superconducting current efficiently, therefore it is preferable to reduce the thickness of the semiconductor layer between the superconductor electrodes thereby to shallow the pn junction. Thus, the arrival of the depletion layer at the surface can be facilitated to enhance the controllability of the superconducting current. This controllability can be enchanced by lowering the concentration of the semiconductor layer between the semiconductor electrodes.

Since, in the present embodiment, the depth of the highly doped p⁺-type region 32 below the superconductor electrodes 34 and 35 is set at 200 nm which is nearly equal to the coherence length of the superconducting electrons, it is possible to sufficiently extend the wave function of the superconducting electrons spreading from the superconductor electrodes 34 and 35 thereby to increase the distance between the electrodes 34 and 35 and the superconducting current. Since, moreover, the semiconductor layer 33 between the superconductor electrodes 34 and 35 is made as thin as 100 nm, it is also possible to increase the changing rate of the superconducting current to the backward bias voltage applied to the pn junction. Since, furthermore, the semiconductor layer 33 is formed as the lightly doped p⁻-type region, it is also possible to control the superconducting current more efficiently.

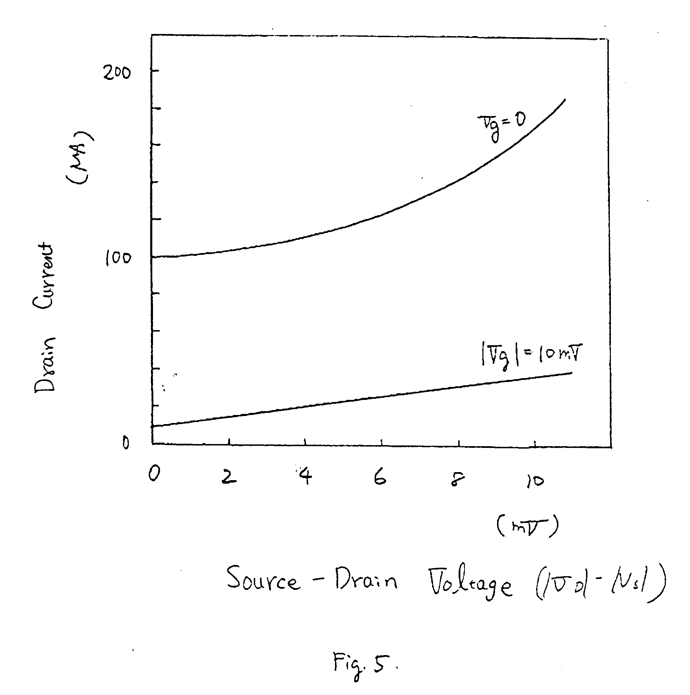

Fig. 5 is a diagram showing the current-voltage characteristics between the superconductor electrodes 34 and 35 at 4.2 K of the semiconductor-coupled superconducting device shown in Figs. 3 and 4. The superconductor electrodes 34 and 35 have sizes of L = 1 »m and W = 3.0 »m, respectively, in Fig. 4. Here, |V_{G}| designates the backward bias voltage |V_{BG} - V_{S}| applied between the n-type silicon substrate 31 and the p⁻ region 33. In this example, V_{S} is ground potential and V_{BG} is OₘV or 10 mV, with V_{D} changing from 0 to 11 mV. When the backward bias voltage is applied, the superconducting current flowing between the superconductor electrodes 34 and 35 is reduced. Additionally, the switching rate is about 10 pico-seconds.

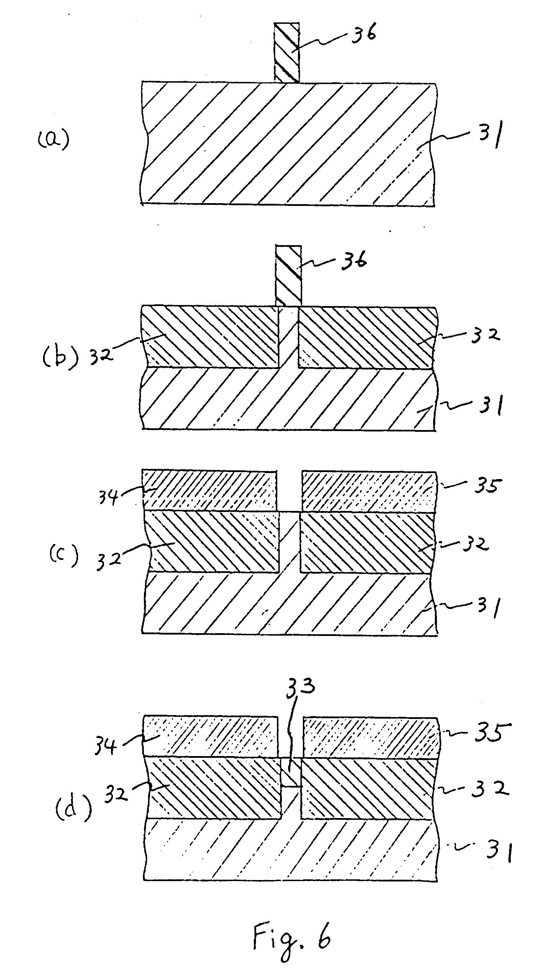

Figs. 6(a) to 6(d) are sectional views showing principal steps for manufacturing the semiconductor-coupled superconducting devices in accordance with the third embodiment shown in Figs. 3 and 4. Referring to Fig. 6(a), a positive-type electron beam resist of poly-methylmetaacrylate (PMMA) having a thickness of 1 »m is applied to the surface of the n-type substrate 31 containing P of 3 x 10¹⁷ atoms/cm³. Next, direct writing by an electron beam is carried out without using any mask under the conditions of an acceleration voltage of 20 KeV and a dosage of 2 x 10⁻⁵ coulombs/cm². By a subsequent development, a thin strip 36 of the resist is formed on the substrate 31, having a width of 0.2 »m.

Next, as shown in Fig. 6(b), the n-type substrate 31 is doped by the ion implantation to form the p⁺-type region 32 having a surface concentration of 5 x 10²⁰ atoms/cm³ and a depth of 200 nm with the resist 36 as a mask. After this, as shown in Fig. 6(c), the Nb film is deposited to have a thickness of 300 nm by a sputtering method and is patterned in acetone,to lift off the resist 36 and a part of the Nb film thereon, thereby forming first and second superconductor electrodes 34 and 35.

After this, as shorn in Fig. 6(d), the p⁻-type region 33 is formed by implanting B ions in the surface concentration of 5 x 10¹⁹ atoms/cm³ into a depth of 100 nm by using the electrodes 34 and 35 as a mask.

When ions are implanted into a superconductor material, crystal defects and damages are caused to drop the critical temperature. Therefore, it is preferable that the superconductor electrodes 34 and 35 be made thicker than the damaged layer formed by the ion implantation. By this thickening, the characteristics of the interface between the superconductor electrodes 34 and 35 and the p⁺-type semiconductor layer 32 are held excellent so that the coherence length of the superconducting electrons is not shortened.

In the semiconductor layer between the superconductor electrodes 34 and 35, as described hereinbefore, the superconducting current takes its maximum in the surface and becomes the smaller in the deeper region. When the superconductor electrodes 34 and 35 are to be formed, therefore, there is desired a process for damaging as little as possible the surface of the semiconductor layer, which is to be exposed between the electrodes. Hence, the RIE (Reactive Ion Etching) process cannot be said a preferable one for working the superconductor electrodes. This is because the components of the superconductor electrodes are imbeded in the surface of the semiconductor layer by ions to degrade the conduction characteristics.

If, as in the present embodiment, the superconductor electrodes are formed by the lift-off process using the resist, the surface of the semiconductor layer is not damaged upon the lift-off so that the semiconductor-coupled superconducting device to be manufactured is remarkably excellent. Moreover, the superconductor electrodes and the channel region can be simultaneously determined in self-alignment by a single pattern transfer step. This makes it possible to improve the fine working precision of the device and to make the manufacturing process convenient.

Next, the third embodiment using an oxide superconductor as the superconductor electrodes 34 and 35 will be described in the following with reference to Figs. 6(a) to 6(d). Referring to Fig. 6(a), the n-type substrate 31 containing P of 5 x 10¹⁷ atoms/cm³ is formed on its surface with the lift-off cutting die 36 of a photo-resist having a width of 0.1 »m.

Next, as shown in Fig. 6(b), the n-type substrate 31 is doped with B by the ion implantation to form the p⁺-type region 32 having a surface concentration of 5 x 10²⁰ atoms/cm³ and a depth of 200 »m.

Next, as shown in Fig. 6(c), yttrium (Y), barium oxide (BaO) and copper (Cu) are sequentially evaporated under a vacuum of 4 x 10⁻⁴ Pa and at a deposition rate of 1 nm/min by the use of an electron gun to form a Y₁Ba₂Cu₃O₇ film having a thickness of 1 »m on the silicon substrate 31 at a temperature of 120°C.

Next, the deposited film is exposed to an argon laser beam in the atmosphere of oxygen gases under a pressure of 1 Pa. The irradiation condition of the argon laser beam is an output of 1 W, a beam diameter of 40 »m, and a scanning speed of 20 mm/sec. As a result, oxygen injection and sintering simultaneously proceed to form the superconductor electrodes 34 and 35 of a superconducting oxide of Y₁Ba₂Cu₃O_{6.9}. The superconductor film deposited on the resist 36 is lifted off simultaneously as the resist 36 is removed by the irradiation with the argon laser beam in the oxygen atmosphere.

After this, as shown in Fig. 6(d), the p⁻-type region 33 is formed by implanting the B ions in a surface concentration of 5 x 10¹⁹ atoms/cm³ and into a depth of 10 nm. Additionally, other oxide superconductors containing bismuth (Bi), strontium (Sr) and calcium (Ca) may be used as the superconductor electrodes 34 anc 35.

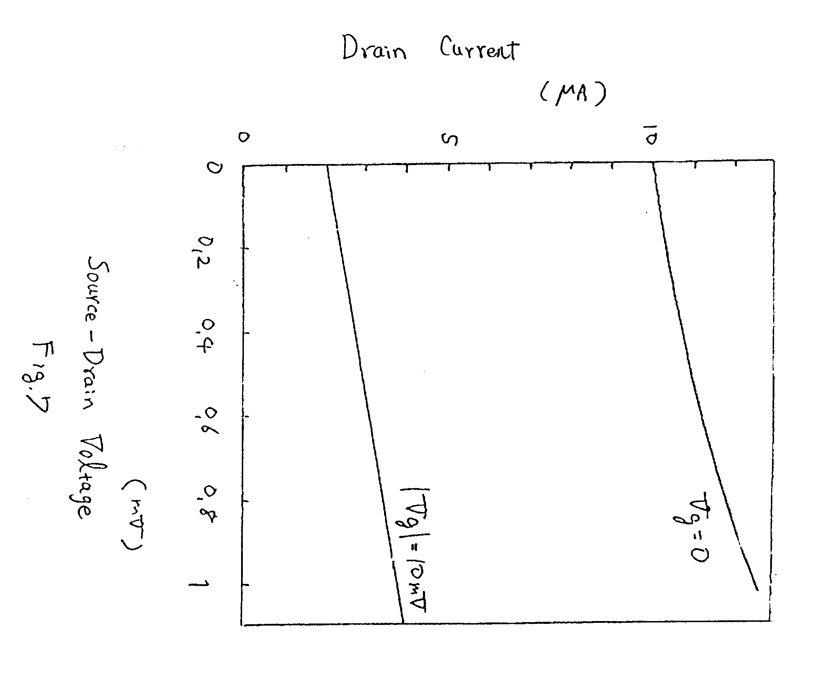

Fig. 7 is a diagram showing the current-voltage characteristics at 80 K of the semiconductor-coupled superconducting device using the oxide superconductor thus prepared. The superconductor electrodes 34 and 35 are made to have the same size of 1 »m x 3 »m as that of the device shown in Fig. 4 according to the second embodiment. The present embodiment can enjoy similar characteristics even at a high temperature of 80 K as those of the second embodiment shown in Fig. 5. Additionally, the switching rate is about 10 pico-seconds.

The semiconductor substrate is made of silicon in the embodiments thus far described but may be made of germanium or compound semiconductors such as InAs, InSb, GaAs, or InP.

With reference to Figs. 6(a) to 6(d), a manufacturing process using GaAs according to a fourth embodiment of the present invention will be described in the order of its steps. Referring to Fig. 6(a), the n-type (100) GaAs substrate 31 containing Si in a concentration of 5 x 10¹⁷ atoms/cm³ is formed on its surface with the lift-off cutting die 36 of a photo-resist having a width of 200 nm.

Next, as shown in Fig. 6(b), the substrate 31 is doped with Mg by the ion implantation at an acceleration voltage of 120 KeV to form the p⁺-type region 32 having a surface concentration of 3 x 10¹⁸ atoms/cm³ and a depth of 200 nm. Next, as shown in Fig. 6(c), the first and second superconductor electrodes 34 anc 35 are formed by depositing a Nb film having a thickness of 300 nm by a sputtering method and by removing the resist in acetone by the lift-off process.

After this, as shown in Fig. 6(d), the p⁻-type region 33 is formed by implanting Mg in a surface at the concentration of 3 x 10¹⁷ atoms/cm³ into a depth of 100 nm by the ion implantation.

Since the coherence length ξ of the superconducting electrons has a relation of ξ ∝ »^{1/2} to the mobility », the distance between the superconductor electrodes can be enlarged so that the device can be easily manufactured and a large superconducting current, can be obtained, when compound semiconductors having high mobility is used as in the present embodiment.

Incidentally, similar effects can be attained even in the conductivity type of the semiconductor layer is inverted in the embodiments thus far described.

Moreover, the superconductor electrodes may be made of a superconducting metal such as Pb, Nb₃Si, Nb₃Sn, NbN, NbCₓN₁₋ₓ or MoN, or an oxide superconductor such as of Ba-Pb-Bi-O, La-Ba-Cu-O, La-Sr-Cu-O, La-Ca-Cu-O, Y-Ba-Cu-O or Bi-Sr-Ca-Cu-O systems, or an oxide superconductor prepared by adding Aℓ or F to those oxide superconductors. The manufacturing process thus far described in connection with the foregoing embodiments can also be applied to the case in which those superconductors are used.

Additionally, it is favorable that the concentrations of the substrates 11, 21 and 31 be 10¹⁴ atoms/cm³ to 10¹⁹ atoms/cm³. It is also favorable that the highly doped semiconductor layers 22 and 32 have an impurity concentration of 10¹⁷ atoms/cm³ to 10²¹ atoms/cm³ whereas the lightly doped semiconductor layers 23 and 33 have a concentration of 10¹⁴ atoms/cm³ to 10²⁰ atoms/cm³. It is further favorable that the concentrations of the highly doped semiconductor layers 22 and 32 is equal to or more than ten times as large as those of the lightly doped semiconductor layers 23 and 33.

It is also favorable that the highly doped semiconductor layers 22 and 32 be as deep as 100 nm to 400 nm whereas the lightly doped semiconductor layer 33 be as deep as 10 nm to 200 nm. The gap between the superconductor electrodes 34 and 35 are favorably equal to or less than twice as long as the coherence length of the superconducting electron pairs, i.e., 10 nm to 400 nm.

## Claims

1. A semiconductor-coupled superconducting device having a first semiconductor layer (21) of one conductivity type, a second semiconductor layer (22) of the other conductivity type formed on said first semiconductor layer, first and second superconductor electrodes (24, 25) formed separately and in contact with the surface of said second semiconductor layer, and a third electrode electrically coupled to daid first semiconductor layer;
said second semiconductor layer (22) including a highly doped region below said first and second superconductor electrodes (24, 25) and a lightly doped region (23) between said first and second superconductor electrodes wherein the distance between said first and second superconductor electrodes is narrower than a length of twice the coherence length of the semiconductor material forming said second semiconductor layer.

2. A semiconductor-coupled superconducting device as claimed in claim 1, wherein said first and second superconductor electrodes (24, 25) are made of a superconducting material selected from a group of Nb, Pb, Nb₃Si, Nb₃Sn, Nbn, NbCₓN₁₋ₓ, MoN and oxide superconductors of Ba-Pb-Bi-O, La-Ba-Cu-O, La-Sr-Cu-O, La-Ca-Cu-O, Y-Ba-Cu-O and Bi-Sr-Ca-Cu-O systems.

3. A semiconductor-coupled superconducting device as claimed in claim 1, wherein said first and second superconductor electrodes (24, 25) are made of a superconducting material containing Nb.

4. A semiconductor-coupled superconducting device as claimed in claim 1, wherein said semiconductor (21, 22) is a material selected from a group of Si, Ge, InAs InSb, GaAs or InP.

## Patentansprüche

1. Halbleitergekoppeltes Supraleiter-Bauelement mit einer ersten Halbleiterschicht (21) eines Leitfähigkeits-Typs, einer zweiten Halbleiterschicht (22) des anderen Leitfähigkeitstyps, welche auf der ersten Halbleiterschicht ausgeformt ist, ersten und zweiten Supraleiterelektroden (24, 25), die getrennt und in Kontakt mit der Oberfläche der zweiten Halbleiterschicht geformt sind, und einer dritten Elektrode, die elektrisch mit der ersten Halbleiterschicht gekoppelt ist, wobei die zweite Halbleiterschicht (22) einen hochdotierten Bereich unterhalb der ersten und zweiten Supraleiterelektrode (24, 25) aufweist und einen leicht dotierten Bereich (23) zwischen der ersten und zweiten Halbleiterelektrode,
wobei der Abstand zwischen der ersten und zweiten Supraleiterelektrode enger ist als zweimal die Kohärenzlänge des Halbleitermaterials, welches die zweite Halbleiterschicht bildet.

2. Zentralprozessoreinheit nach Anspruch 1,
wobei die erste und zweite Supraleiterelektrode (24, 25) aus einem supraleitenden Material besteht, das aus der Gruppe Nb, Pb, Nb₃Si, Nb₃Sn, Nbn, NcCₓN₁₋ₓ, MoN und Oxidsuperleitern aus dem Ba-Pb-Bi-O, La-Ba-Cu-O, La-Sr-Cu-O, La-Ca-Cu-O, Y-Ba-Cu-O-System ausgewählt ist.

3. Zentralprozessoreinheit nach Anspruch 1,
dadurch **gekennzeichnet,** daß die erste und zweite Supraleiterelektrode (24, 25) aus einem Nb-enthaltenden, supraleitenden Material besteht.

4. Zentralprozessoreinheit nach Anspruch 1,
dadurch **gekennzeichnet,** daß der Halbleiter (21, 22) ein Material ist aus der Gruppe Si, Ge, InAs, InSb, GaAs oder InP.

## Revendications

1. Dispositif supraconducteur couplé par semi-conducteur comportant une première couche semi-conductrice (21) d'un premier type de conductivité, d'une seconde couche semi-conductrice (22) de l'autre type de conductivité formée sur ladite première couche semi-conductrice, des première et seconde électrodes supraconductrices (24, 25) formées séparément et en contact avec la surface de ladite seconde couche semi-conductrice et une troisième électrode électriquement couplée à ladite première couche semi-conductrice,
ladite seconde couche semi-conductrice (22) comportant une région fortement dopée en-dessous desdites première et seconde électrodes supraconductrices (24 et 25) et une région légèrement dopée (23) située entre lesdites première et seconde électrodes supraconductrices dans laquelle la distance entre lesdites première et seconde électrodes supraconductrices est plus faible que deux fois la longueur de la longueur de cohérence du matériau semi-conducteur formant ladite seconde couche semi-conductrice.

2. Dispositif supraconducteur couplé par semi-conducteur selon la revendication 1, dans lequel lesdites première et seconde électrodes supraconductrices (24, 25) sont constituées d'un matériau supraconducteur choisi dans le groupe de Nb, Pb, Nb₃Si, Nb₃Sn, Nbn, NbC_{X}N_{1-X}, MoN et des supraconducteurs d'oxyde des systèmes de Ba-Pb-Bi-O, La-Ba-Cu-O, La-Sr-Cu-O, La-Ca-Cu-O, Y-Ba-Cu-O et Bi-Sr-Ca-Cu-O.

3. Dispositif supraconducteur couplé par semi-conducteur selon la revendication 1, dans lequel lesdites première et seconde électrodes supraconductrices (24, 25) sont constituées d'un matériau supraconducteur contenant Nb.

4. Dispositif supraconducteur couplé par semi-conducteur selon la revendication 1, dans lequel ledit semi-conducteur (21, 22) est un matériau choisi dans le groupe constitué de Si, Ge, InAs InSb, GaAs ou InP.
